# EUROPEAN PATENT SPECIFICATION

(11) **EP 1 809 477 B1**
(45) Date of publication and mention of the grant of the patent: **28.03.2012**
(21) Application number: 05801588.4
(22) Date of filing: 19.10.2005
(51) Int. Cl.: B41C 1/14, B41N 1/24, G03F 7/12, B41F 15/34

(54) **MANDRELS FOR ELECTROFORMING PRINTING SCREENS, AND ELECTROFORMING APPARATUS**
DORNE ZUM ELEKTROFORMEN VON DRUCKSCHABLONEN UND ELEKTROFORMVORRICHTUNG
MANDRINS POUR ÉLECTROFORMAGE D'ÉCRANS D'IMPRESSION, ET APPAREIL D'ÉLECTROFORMAGE

(30) Priority: 20.10.2004 GB 0423263
(43) Date of publication of application: 25.07.2007
(73) Proprietor: DTG International GmbH, 8005 Zürich (CH)
(72) Inventor: BAILEY, Lee Edward James, Weymouth, Dorset DT3 5JA (GB)
(74) Representative: Boden, Keith McMurray
(86) International application number: PCT/GB2005/004016
(87) International publication number: WO 2006/043049

(56) References cited:
- WO-A-02/058930
- WO-A-03/093012
- US-A- 3 372 639

## Description

The present invention relates to a mandrel for electroforming printing screens, an electroforming system for electroforming printing screens, a method of electroforming printing screens, and an electroformed printing screen which incorporates attachment elements at the edges thereof for mechanical engagement with a mounting frame.

Printing screens, which are often alternatively referred to as printing stencils, are used in the manufacture of circuit boards in printing a medium, typically either a solder paste or an adhesive, onto a circuit board.

WO-A-2003/093012 discloses a printing screen for use in the screen printing of workpieces.

Electroforming has been commonly used to fabricate flat printing screens, with such printing screens being disclosed, for example, in US-A-5359928 and US-A-5478699.

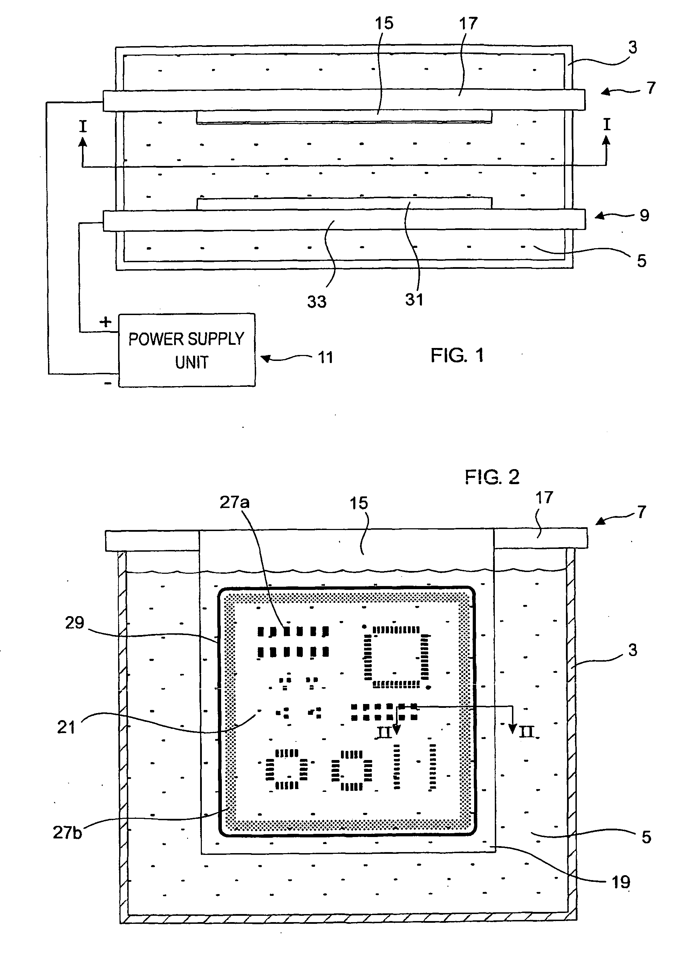

The electroforming of such printing screens will now be described with reference to Figures 1 to 6.

The electroforming system comprises a bath 3 which contains an electrolyte solution 5, a mandrel unit 7 which is disposed in the bath 3 and onto which metal is electrodeposited to form a printing screen, an anode unit 9 which is disposed in the bath 3 such as to provide a source of ions of the metal to be deposited, and a power supply unit 11 which is electrically connected to the mandrel unit 7 and the anode unit 9 and operable to drive an electric current through the electrolyte solution 5, with the negative supply of the power supply unit 11 being connected to the mandrel unit 7 and the positive supply of the power supply unit 11 being connected to the anode unit 9.

The electrolyte solution 5 is typically an aqueous solution which contains a dissolved salt of the metal to be deposited, commonly nickel, and levellers which provide for control of the hardness of the deposited metal.

The mandrel unit 7 comprises a mandrel 15 onto which a printing screen is to be electroformed, and a supporting member 17, typically a supporting bar, for supporting the mandrel 15 in the bath 3 and providing an electrical connection therewith.

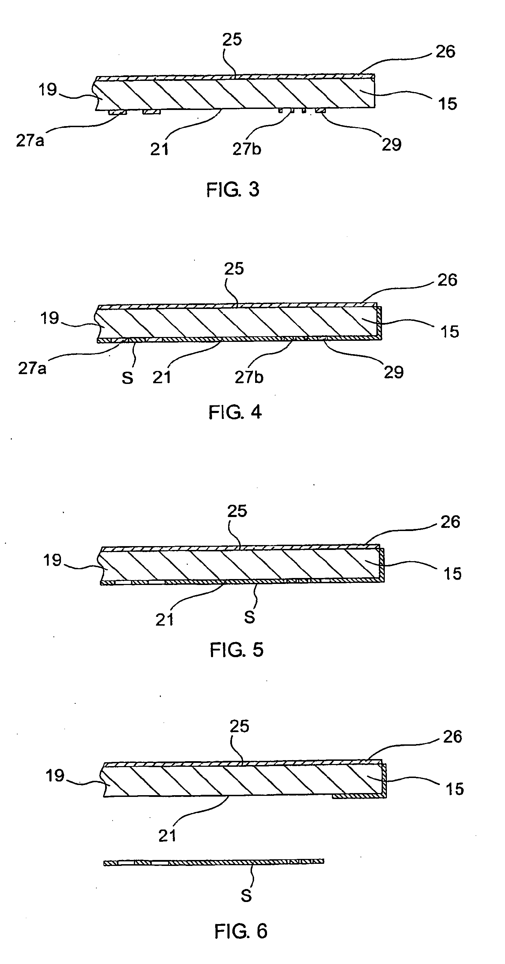

Figure 3 illustrates a fragmentary sectional view through the mandrel 15.

The mandrel 15 comprises a flat metal plate 19, typically rectangular in shape, which includes first and second oppositely-directed flat, major surfaces 21, 25, where one major surface 21 is a deposition surface onto which metal is deposited to form a printing screen, as will be described in more detail hereinbelow.

The mandrel 15 further comprises a plurality of non-conductive aperture-defining elements 27a, 27b, formed of resist, which shield regions on the deposition surface 21 onto which metal is not to be deposited, with these elements 27a, 27b corresponding to the apertures to be formed in the printing screen, both as printing apertures through which a pattern of a printing medium is to be printed and attachment apertures which key to a bonding glue in attachment to a mounting frame, and a non-conductive bounding element 29, formed of resist, which bounds a region of the deposition surface 21 and defines the extent of the printing screen to be formed.

The mandrel 15 further comprises a non-conductive surface-covering element 26, formed of resist, on the other major surface 25 which acts to prevent the deposition of metal thereon.

The anode unit 9 comprises an anode plate 31, typically of the same rectangular shape as the mandrel 15, which is formed of the metal to be deposited as the printing screen, and a supporting member 33, typically a supporting bar, for supporting the anode plate 31 in the bath 3 and providing an electrical connection therewith.

In a preferred arrangement the deposition surface 21 of the mandrel 15 and the anode plate 31 are disposed in opposed, parallel relation at a predetermined spacing.

In operation, the power supply unit 11 is actuated to drive an electric current through the electrolyte solution 5 between the mandrel unit 7 and the anode unit 9. This current causes metal ions to migrate from the anode plate 31 to the exposed regions of the deposition surface 21 of the mandrel plate 19, at which exposed regions the metal ions deposit as the metal, building up the printing screen by the continued deposition of metal on the deposition surface 21 of the mandrel plate 19.

This process is allowed to continue until a layer of the required thickness, which constitutes a printing screen S, has been built up on the deposition surface 21 of the mandrel plate 19, as illustrated in Figure 4, at which point the power supply unit 11 is de-actuated and the mandrel unit 7 removed from the bath 3.

The non-conductive elements 27a, 27b, 29 on the deposition surface 21 of the mandrel plate 19 are then removed, by stripping the resist, leaving the printing screen S, as illustrated in Figure 5.

The printing screen S is then separated from the mandrel 15, as illustrated in Figure 6, by lifting at the edges revealed by removal of the bounding element 29, and, following cleaning, is ready for use.

Electroforming has also been used to fabricate a printing screen which incorporates upstanding attachment elements which encompass the periphery of the main body of the printing screen and provide for fixing of the printing screen over a mounting frame which maintains the printing screen at a predetermined tension, with the electroforming of such a printing screen being disclosed in EP-A-0029348.

US-A-3372639 discloses a mandrel for making electrostatic printing screens.

Whilst electroforming is increasingly being used to fabricate printing screens, the existing electroformed printing screens do not allow for mounting in a mounting frame and the repeated, active tensioning of the printing screen between tensioned and untensioned states while mounted in the mounting frame.

It is thus an aim of the present invention to provide a mandrel for electroforming printing screens, an electroforming system for electroforming printing screens, a method of electroforming printing screens, and an electroformed printing screen which incorporates attachment elements at the edges thereof which allow for repeated, active tensioning of the printing screen between tensioned and untensioned states while mounted in a mounting frame.

In one aspect the present invention provides a mandrel for electroforming printing screens, the mandrel comprising: a mandrel plate onto which metal is to be deposited to form a printing screen, the mandrel plate including a main deposition surface onto which metal is to be deposited to define a main body of the printing screen, at least one pair of edge sections at opposed edges of the main deposition surface which include edge deposition surfaces which extend out of a plane defined by the main deposition surface onto which metal is to be deposited to define attachment elements of the printing screen, and corner sections at respective corners of the deposition surface; non-conductive elements, as edge elements, which are disposed at the edge sections such as to define an extent of the edge sections; and non-conductive elements, as corner elements, which are disposed at the corner sections such as to shield the same and define an extent of the main deposition surface at the corner sections.

In one embodiment the mandrel further comprises: non-conductive elements disposed on the main deposition surface which shield regions of the main deposition surface, corresponding to printing apertures, onto which metal is not to be deposited.

In one embodiment each edge deposition surface includes a surface section which extends laterally relative to the main deposition surface.

In one embodiment the surface section extends laterally outwardly relative to the respective edge of the main deposition surface, which provides for deposition of an outwardly-projecting part.

In another embodiment the surface section extends laterally inwardly relative to the respective edge of the main deposition surface, which provides for deposition of an inwardly-projecting part.

Preferably, the surface section returns inwardly a distance of about 0.5 mm.

In one embodiment the surface section comprises a substantially straight section.

In another embodiment the surface section comprises an arcuate section.

In one embodiment the surface section extends rearwardly of the main deposition surface.

In another embodiment each edge deposition surface includes first and second surface sections, wherein the first surface section extends substantially orthogonally relative to the main deposition surface and the second surface section extends laterally relative to the main deposition surface.

In one embodiment the second surface section extends laterally outwardly relative to the respective edge of the main deposition surface, which provides for deposition of an outwardly-projecting part.

In another embodiment the second surface section extends laterally inwardly relative to the respective edge of the main deposition surface, which provides for deposition of an inwardly-projecting part.

Preferably, the second surface section returns inwardly a distance of about 0.5 mm.

In one embodiment the second surface section comprises a substantially straight section.

In another embodiment the second surface section comprises an arcuate section.

In one embodiment the first surface section extends from the respective edge of the main deposition surface and the second surface section extends from the first surface section.

In another embodiment the second surface section extends from the respective edge of the main deposition surface and the first surface section extends from the second surface section.

In one embodiment the first and second surface sections extend rearwardly of the main deposition surface.

In a further embodiment each edge deposition surface includes first and second surface sections, wherein the first surface section extends laterally in one sense relative to the main deposition surface and the second surface section extends laterally in the other sense relative to the main deposition surface.

In one embodiment the first surface section extends laterally outwardly relative to the respective edge of the main deposition surface, which provides for deposition of an outwardly-projecting part, and the second surface section extends laterally inwardly relative to the respective edge of the main deposition surface, which provides for deposition of an inwardly-projecting part.

Preferably, the second surface section returns inwardly a distance of about 0.5 mm.

In one embodiment one or both of the first and second surface sections comprise a substantially straight section.

In one embodiment one or both of the first and second surface sections comprise an arcuate section.

In one embodiment the first and second surface sections extend rearwardly of the main deposition surface.

In a yet further embodiment the edge sections each comprise a channel at the respective edge of the main deposition surface in which metal is deposited to form an attachment element.

Preferably, the channel has a width of about 0.5 mm to about 0.6 mm.

Preferably, the channel has a width of about 0.5 mm or about 0.6 mm.

In one embodiment the channel has a substantially U-shaped section.

In one embodiment the mandrel plate includes first and second pairs of edge sections at opposed edges of the main deposition surface.

Preferably, the edge sections and the corner sections define a continuous peripheral section.

The present invention also extends to an electroforming system including the above-described mandrel.

The present invention further extends to a method of electroforming printing screens, comprising the steps of: providing the above-described mandrel in an electroforming bath; and electrodepositing metal on the mandrel plate such as to form a printing screen.

In another aspect the present invention provides an electroformed printing screen, comprising a main body including a pattern of printing apertures through which a printing medium is in use printed, and at least one pair of attachment elements at opposed edges of the main body, wherein the attachment elements each extend out of a plane defined by the main body and along only part of a length of the respective edge of the main body.

In one embodiment each corner of the main body is recessed or cut away, such that the attachment elements are separate from one another,

In one embodiment each attachment element includes a projecting part which extends laterally relative to the respective edge of the main body.

In one embodiment the projecting part extends laterally outwardly relative to the respective edge of the main body.

In another embodiment the projecting part extends laterally inwardly relative to the respective edge of the main body.

Preferably, the projecting part returns inwardly a distance of about 0.5 mm.

In one embodiment the projecting part comprises a substantially straight section.

In another embodiment the projecting part comprises an arcuate section.

In one embodiment the projecting part extends rearwardly of the main body.

In another embodiment each attachment element includes first and second projecting parts, wherein the first projecting part extends substantially orthogonally relative to the main body and the second projecting part extends laterally relative to the main body.

In one embodiment the second projecting part extends laterally outwardly relative to the respective edge of the main body.

In another embodiment the second projecting part extends laterally inwardly relative to the respective edge of the main body.

Preferably, the second projecting part returns inwardly a distance of about 0.5 mm.

In one embodiment the second projecting part comprises a substantially straight section.

In another embodiment the second projecting part comprises an arcuate section.

In one embodiment the first projecting part extends from the respective edge of the main body and the second projecting part extends from the first projecting part.

In another embodiment the second projecting part extends from the respective edge of the main body and the first projecting part extends from the second projecting part.

In one embodiment the first and second projecting parts extend rearwardly of the main body.

In a further embodiment each attachment element includes first and second projecting parts, wherein the first projecting part extends laterally in one sense relative to the main body and the second projecting part extends laterally in the other sense relative to the main body.

In one embodiment the first projecting part extends laterally outwardly relative to the respective edge of the main body, and the second projecting part extends laterally inwardly relative to the respective edge of the main body.

Preferably, the second projecting part returns inwardly a distance of about 0.5 mm.

In one embodiment one or both of the first and second projecting parts comprise a substantially straight section.

In another embodiment one or both of the first and second projecting parts comprise an arcuate section.

In one embodiment the first and second projecting parts extend rearwardly of the main body.

In a yet further embodiment the attachment elements each comprise an open section.

Preferably, the open section has a width of about 0.5 mm to about 0.6 mm.

Preferably, the open section has a width of about 0.5 mm or about 0.6 mm.

In one embodiment the open section comprises a substantially U-shaped section.

In a still further embodiment the attachment elements each comprise a bead.

Preferably, the bead has a width of about 0.5 mm to about 0.6 mm.

Preferably, the bead has a width of about 0.5 mm or about 0.6 mm.

In one embodiment the bead comprises a hollow body.

In one embodiment the printing screen comprises first and second pairs of opposed attachment elements.

Preferred embodiments of the present invention will now be described hereinbelow by way of example only with reference to the accompanying drawings, in which:
Figure 1 illustrates a representative prior art electroforming system;
Figure 2 illustrates a vertical sectional view (along section I-I in Figure 1) through the electroforming bath of the electroforming system of Figure 1;
Figure 3 illustrates a sectional view (along section II-II in Figure 2) of the mandrel of the electroforming system of Figure 1;
Figure 4 illustrate a sectional view (along section II-II in Figure 2) of the mandrel of the electroforming system of Figure 1, where including a printing screen electroformed thereon;
Figure 5 illustrates a sectional view (along section II-II in Figure 2) of the mandrel of the electroforming system of Figure 1, where the aperture-defining and bounding elements are removed from the deposition surface of the mandrel following formation of the printing screen;
Figure 6 illustrates a sectional view (along section II-II in Figure 2) of the mandrel of the electroforming system of Figure 1, where the electroformed printing screen is removed from the deposition surface of the mandrel;
Figure 7 illustrates an electroforming system in accordance with a first embodiment of the present invention;
Figure 8 illustrates a vertical sectional view (along section III-III in Figure 7) through the electroforming bath of the electroforming system of Figure 7;
Figure 9 illustrates a sectional view (along section IV-IV in Figure 8) of one edge section of the mandrel of the electroforming system of Figure 7;
Figure 10 illustrates a sectional view (along section V-V in Figure 8) of one of the other edge sections of the mandrel of the electroforming system of Figure 7;
Figure 11 illustrates a plan view (region A in Figure 8) of one of the corner sections of the mandrel of the electroforming system of Figure 7;
Figure 12 illustrates a sectional view (along section VI-VI in Figure 11) of one of the corner sections of the mandrel of the electroforming system of Figure 7;
Figure 13 illustrates a sectional view (along section V-V in Figure 8) of one of the edge sections of the mandrel of the electroforming system of Figure 7, where including a printing screen in accordance with a first embodiment of the present invention electroformed thereon;
Figure 14 illustrates a sectional view (along section VI-VI in Figure 11) of one of the corner sections of the mandrel of the electroforming system of Figure 7, where including a printing screen in accordance with a first embodiment of the present invention electroformed thereon;
Figure 15 illustrates an attachment element formed at one edge of the printing screen in accordance with the first embodiment of the present invention where located in a representative frame member of a mounting frame;
Figure 16 illustrates a sectional view (along section IV-IV in Figure 8) of one edge section of a mandrel as one modification of the electroforming system of Figure 7;
Figure 17 illustrates a sectional view (along section V-V in Figure 8) of one of the other edge sections of the mandrel of the one modification of the electroforming system of Figure 7;
Figure 18 illustrates a plan view (region. A in Figure 8) of one of the corner sections of the mandrel of the one modification of the electroforming system of Figure 7;
Figure 19 illustrates a sectional view (along section VI-VI in Figure 11) of one of the corner sections of the mandrel of the one modification of the electroforming system of Figure 7;
Figure 20 illustrates a sectional view (along section V-V in Figure 8) of one of the edge sections of the mandrel of the one modification of the electroforming system of Figure 7, where including a printing screen in accordance with a second embodiment of the present invention electroformed thereon;
Figure 21 illustrates a sectional view (along section VI-VI in Figure 11) of one of the corner sections of the mandrel of the one modification of the electroforming system of Figure 7, where including a printing screen in accordance with a second embodiment of the present invention electroformed thereon;
Figure 22 illustrates an attachment element formed at one edge of the printing screen in accordance with the second embodiment of the present invention where located in a representative frame member of a mounting frame;
Figure 23 illustrates a sectional view (along section IV-IV in Figure 8) of one edge section of a mandrel as another modification of the electroforming system of Figure 7;
Figure 24 illustrates a sectional view (along section V-V in Figure 8) of one of the other edge sections of the mandrel of the other modification of the electroforming system of Figure 7;
Figure 25 illustrates a plan view (region A in Figure 8) of one of the corner sections of the mandrel of the other modification of the electroforming system of Figure 7;
Figure 26 illustrates a sectional view (along section VI-VI in Figure 11) of one of the corner sections of the mandrel of the other modification of the electroforming system of Figure 7;
Figure 27 illustrates a sectional view (along section V-V in Figure 8) of one of the edge sections of the mandrel of the other modification of the electroforming system of Figure 7, where including a printing screen in accordance with a third embodiment of the present invention electroformed thereon;
Figure 28 illustrates a sectional view (along section VI-VI in Figure 11) of one of the corner sections of the mandrel of the other modification of the electroforming system of Figure 7, where including a printing screen in accordance with a third embodiment of the present invention electroformed thereon;
Figure 29 illustrates an attachment element formed at one edge of the printing screen in accordance with the third embodiment of the present invention where located in a representative frame member of a mounting frame;
Figure 30 illustrates an electroforming system in accordance with a second embodiment of the present invention;
Figure 31 illustrates a vertical sectional view (along section VII-VII in Figure 30) through the electroforming bath of the electroforming system of Figure 30;
Figure 32 illustrates a plan view (region B in Figure 31) of one of the corner sections of the mandrel of the electroforming system of Figure 30;
Figure 33 illustrates a sectional view (along section VIII-VIII in Figure 32) of one of the edge sections of the mandrel of the electroforming system of Figure 30;
Figure 34 illustrates a sectional view (along section IX-IX in Figure 32) of one of the corner sections of the mandrel of the electroforming system of Figure 30;
Figure 35 illustrates a sectional view (along section VIII-VIII in Figure 32) of one of the edge sections of the mandrel of the electroforming system of Figure 30, where including a printing screen in accordance with a fourth embodiment of the present invention electroformed thereon;
Figure 36 illustrates a sectional view (along section IX-IX in Figure 32) of one of the corner sections of the mandrel of the electroforming system of Figure 30, where including a printing screen in accordance with a fourth embodiment of the present invention electroformed thereon; and
Figure 37 illustrates an attachment element formed at one edge of the printing screen in accordance with the fourth embodiment of the present invention where located in a representative frame member of a mounting frame.

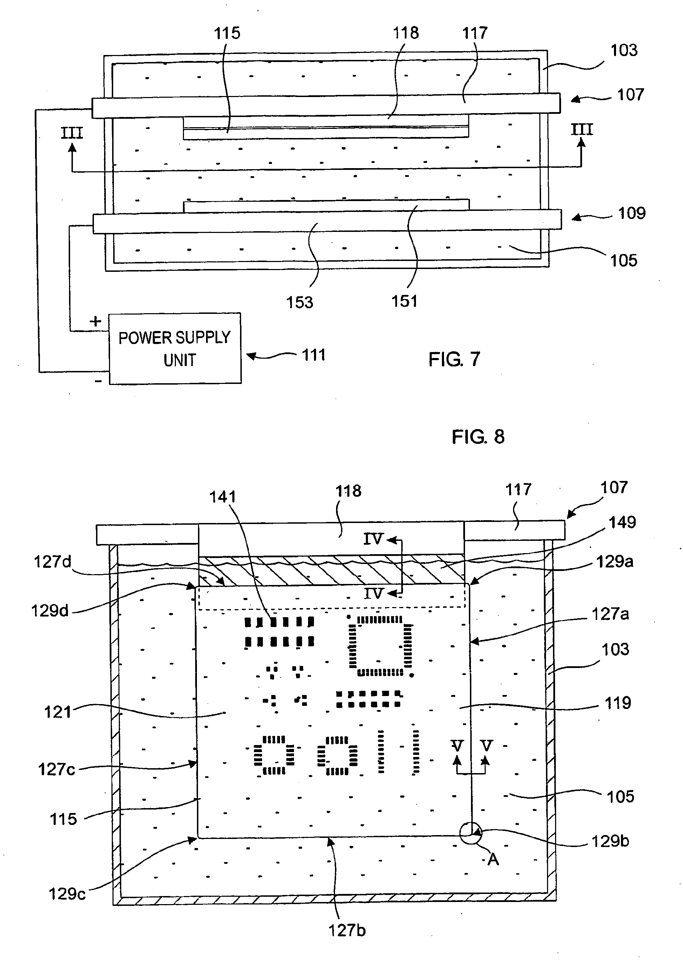

Figures 7 to 14 illustrate an electroforming system in accordance with a first embodiment of the present invention.

The electroforming system comprises a bath 103 which contains an electrolyte solution 105, a mandrel unit 107 which is disposed in the bath 103 and onto which a printing screen S is to be electroformed, an anode unit 109 which is disposed in the bath 103 such as to provide a source of ions of the metal to be deposited, and a power supply unit 111 which is electrically connected to the mandrel unit 107 and the anode unit 109 and operable to drive an electric current through the electrolyte solution 105, with the negative supply of the power supply unit 111 being connected to the mandrel unit 107 and the positive supply of the power supply unit 111 being connected to the anode unit 109.

The electrolyte solution 105 is typically an aqueous solution which contains a dissolved salt of the metal to be deposited, commonly nickel, and levellers which provide for control of the hardness of the deposited metal.

The mandrel unit 107 comprises a mandrel 115 onto which the printing screen S is to be electroformed, a supporting member 117, in this embodiment a supporting bar, for supporting the mandrel 115 in the bath 103 and providing an electrical connection therewith, and an interconnecting member 118 for mechanically and electrically interconnecting the mandrel 115 to the supporting member 117.

The mandrel 115 comprises a flat metal mandrel plate 119 which includes first and second oppositely-directed flat, major surfaces 121, 125, where one major surface 121 is a deposition surface onto which metal is deposited to form the printing screen S, as will be described in more detail hereinbelow.

In this embodiment the mandrel plate 119 comprises a substantially rectangular metal plate which includes first to fourth substantially straight outer edge sections 127a-d and first to fourth corner sections 129a-d, here of arcuate shape, which connect respective ones of the edge sections 127a-d. In this embodiment the edge and corner sections 127a-d, 129a-d define a continuous peripheral section.

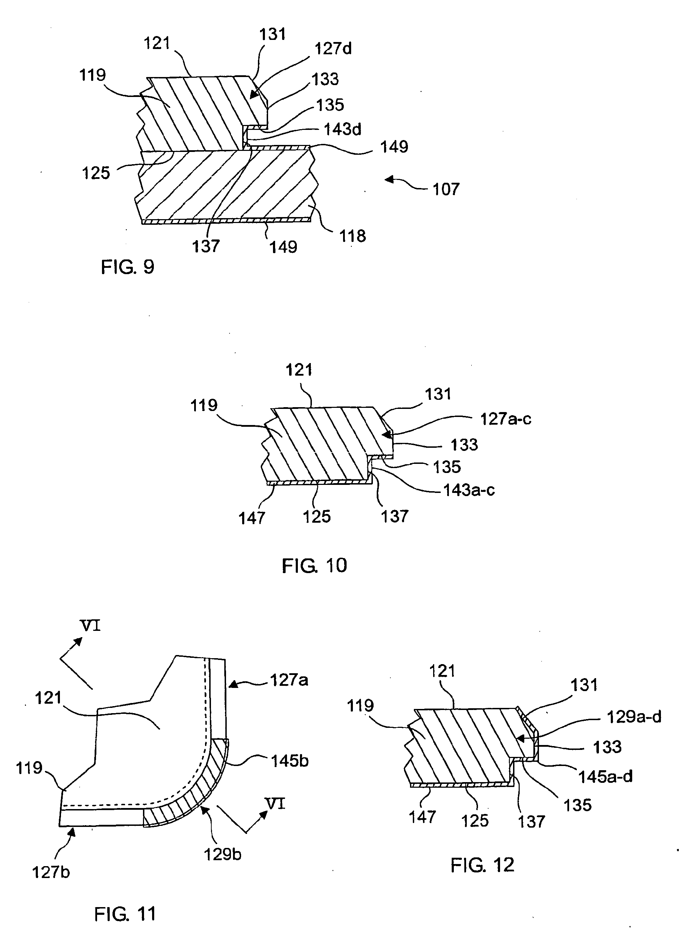

Referring particularly to Figures 9 and 10, each of the edge sections 127a-d comprises a first, inclined surface 131 which is inclined outwardly and rearwardly from the respective edge of the deposition surface 121 such as to extend at an obtuse angle therefrom, a second, outer surface 133 which extends from the outer end of the inclined surface 131 in a direction substantially perpendicular to the deposition surface 121, a third, return surface 135 which extends inwardly from the lower end of the outer surface 133 in a direction substantially parallel to the deposition surface 121, and a fourth, recessed surface 137 which extends from the inner end of the return surface 135 to the other major surface 125 in a direction substantially perpendicular to the deposition surface 121. As will be described in more detail hereinbelow, the inclined and outer surfaces 131, 133 remain exposed to receive metal deposit, resulting in the formation of rearwardly and outwardly depending attachment elements E of the electroformed printing screen S.

The mandrel 115 further comprises a plurality of non-conductive aperture-defining elements 141, in this embodiment formed of resist, disposed on the deposition surface 121 which shield regions of the deposition surface 121 onto which metal is not to be deposited, with these elements 141 corresponding to the apertures to be formed in the printing screen S, in this embodiment printing apertures through which a pattern of a printing medium is to be printed.

Referring particularly to Figures 9 and 10, the mandrel 115 further comprises first to fourth non-conductive edge elements 143a-d, in this embodiment formed of resist, which each shield the return and recessed surfaces 135, 137 of a respective one of the edge sections 127a-d, leaving the inclined and outer surfaces 131, 133 of the edge sections 127a-d exposed to receive metal deposit.

Referring particularly to Figures 11 and 12, the mandrel 115 further comprises non-conductive corner elements 145a-d, in this embodiment formed of resist, which each shield a respective one of the corner sections 129a-d, such that deposit is received only on the substantially straight edge sections 127a-d.

Referring particularly to Figures 10 and 12, the mandrel 115 further comprises a non-conductive surface-covering element 147, in this embodiment formed of resist, which shields the other major surface 125 of the mandrel plate 119, such as to prevent the deposition of metal thereon.

Referring particularly to Figure 9, the mandrel unit 107 further comprises a non-conductive surface-covering element 149, in this embodiment formed of resist, which shields the interconnecting member 118, such as to prevent the deposition of metal thereon.

The anode unit 109 comprises an anode plate 151, in this embodiment of the same rectangular shape as the mandrel 115, which is formed of the metal to be deposited as the printing screen S, and a supporting member 153, in this embodiment a supporting bar, for supporting the anode plate 151 in the bath 103 and providing an electrical connection therewith.

In a preferred embodiment the deposition surface 121 of the mandrel plate 119 and the anode plate 151 are disposed in opposed, parallel relation at a Predetermined spacing.

In operation, the power supply unit 111 is actuated to drive an electric current through the electrolyte solution 105 between the mandrel unit 107 and the anode unit 109. This current causes metal ions to migrate from the anode plate 151 to the exposed surfaces of the mandrel plate 119, at which exposed surfaces, that is, the exposed regions of the deposition surface 121 and the exposed inclined and outer surfaces 131, 133 of the edge sections 127a-d, the metal ions deposit as the metal, building up the printing screen S by continued deposition on the mandrel plate 119.

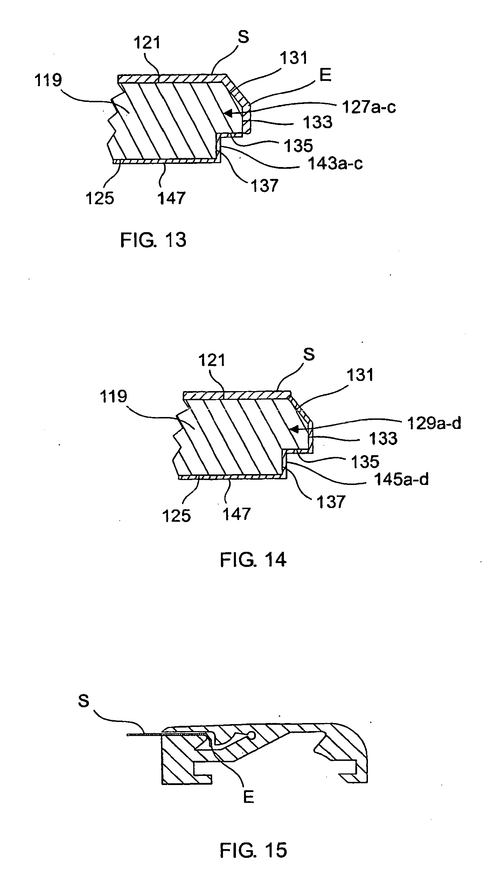

This process is allowed to continue until a deposit of the required thickness, which constitutes the printing screen S, has been built up on the mandrel 115, as illustrated in Figures 13 and 14, at which point the power supply unit 111 is de-actuated and the mandrel unit 107 removed from the bath 103. Figures 13 and 14 illustrate a printing screen S in accordance with a first embodiment of the present invention, which includes attachment elements E at the respective edges thereof.

The non-conductive elements 141, 143a-d, 145a-d, 147, 149 are then removed, in this embodiment by stripping the resist, leaving the printing screen S.

The printing screen S is then separated from the mandrel 115, and, following cleaning, is ready for use.
Figure 15 illustrates the location of the attachment element E formed at one edge of the printing screen S in a representative frame member of a mounting frame.

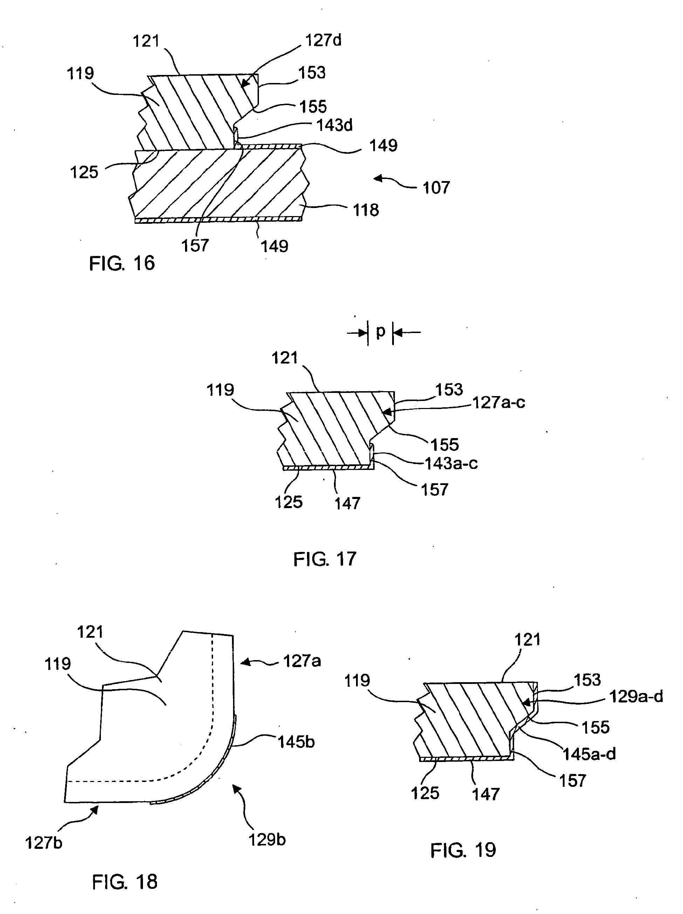

Figures 16 to 21 illustrate fragmentary views of a mandrel unit 107 as one modification of the first-described embodiment.

The mandrel unit 107 of this embodiment is very similar to that of the above-described first embodiment, and differs only in the configuration of the edge and corner sections 127a-d, 129a-d of the mandrel plate 119.

In this embodiment each of the edge sections 127a-d comprises a first, outer surface 153 which extends from the respective edge of the deposition surface 121 in a direction substantially perpendicular thereto, a second, return surface 155 which extends inwardly and rearwardly from the lower end of the outer surface 153, and a third, recessed surface 157 which extends from the inner end of the return surface 155 to the other major surface 125 in a direction substantially perpendicular to the deposition surface 121. As will be described in more detail hereinbelow, the outer and return surfaces 153, 155 remain exposed to receive metal deposit, resulting in rearwardly and inwardly extending attachment elements E of the electroformed printing screen S.

In this embodiment the first to fourth non-conductive edge elements 143a-d each shield the recessed surface 157 of a respective one of the edge sections 127a-d, leaving the outer and return surfaces 153, 155 of the edge sections 127a-d exposed to receive metal deposit.

In this embodiment the non-conductive corner elements 145a-d each shield a respective one of the corner sections 129a-d, such that deposit is received only on the substantially straight edge sections 127a-d.

In this embodiment the return surfaces 155, and thus the attachment elements E of the printing screen S, have a lateral projection p in a plane parallel to the deposition surface 121 of about 0.5 mm. As a consequence of the relatively small extent of the lateral projection p and the rearward taper of the return surface 155, and thus the attachment elements E of the printing screen S, the resilience, albeit limited, of the printing screen S allows the printing screen S to be released from the mandrel 115.

In operation, the power supply unit 111 is actuated to drive an electric current through the electrolyte solution 105 between the mandrel unit 107 and the anode unit 109. This current causes metal ions to migrate from the anode plate 151 to the exposed surfaces of the mandrel plate 119, at which exposed surfaces, that is, the exposed regions of the deposition surface 121 and the outer and return surfaces 153, 155 of the edge sections 127a-d, the metal ions deposit as the metal, building up the printing screen S by continued deposition on the mandrel plate 119.

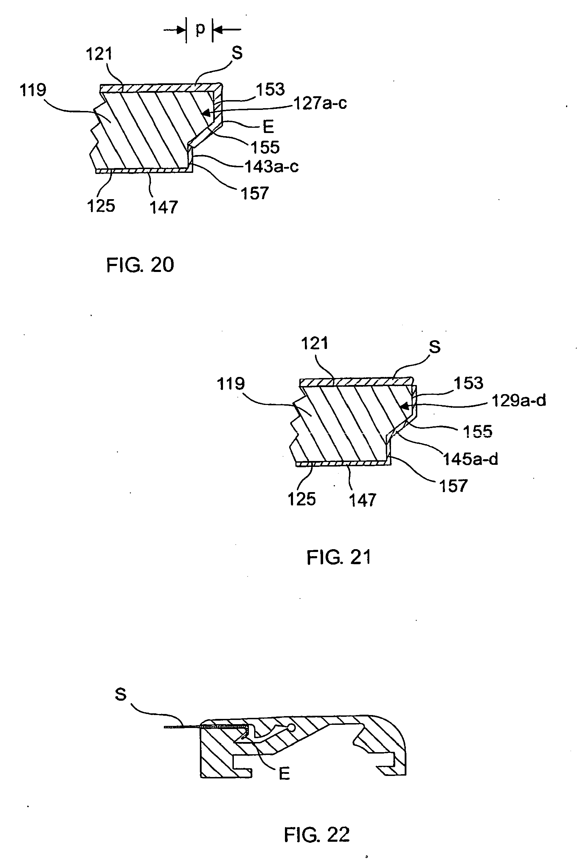

This process is allowed to continue until a deposit of the required thickness, which constitutes the printing screen S, has been built up on the mandrel 115, as illustrated in Figures 20 and 21, at which point the power supply unit 111 is de-actuated and the mandrel unit 107 removed from the bath 103. Figures 20 and 21 illustrate a printing screen S in accordance with a second embodiment of the present invention, which includes attachment elements E at the respective edges thereof.

The non-conductive elements 141, 143a-d, 145a-d, 147 are then removed, in this embodiment by stripping the resist, leaving the printing screen S.

The printing screen S is then separated from the mandrel 115, and, following cleaning, is ready for use.
Figure 22 illustrates the location of the attachment element E formed at one edge of the printing screen S in a representative frame member of a mounting frame.

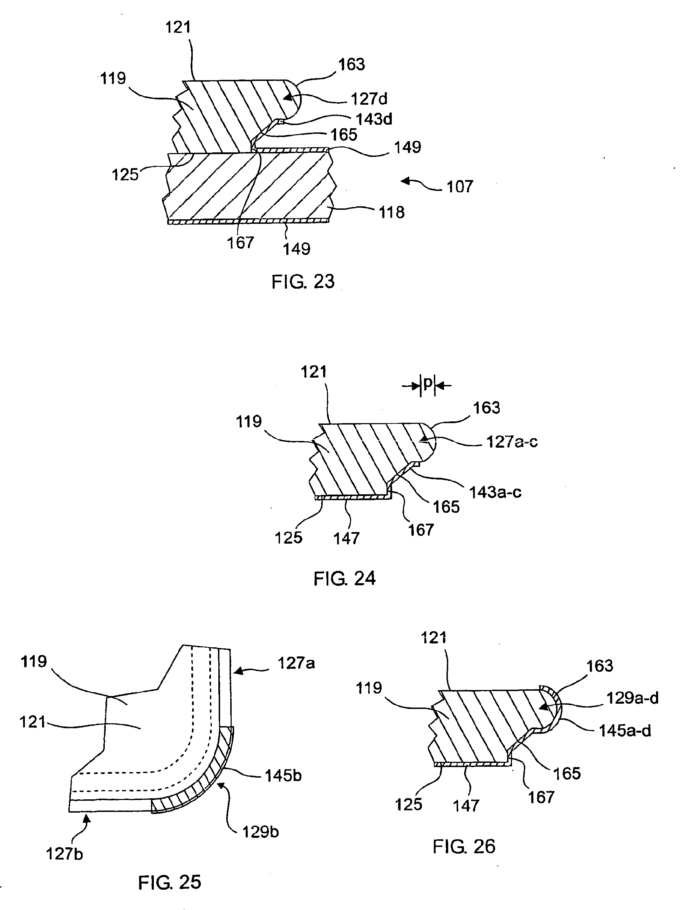

Figures 23 to 28 illustrate fragmentary views of a mandrel unit 107 as another modification of the first-described embodiment.

The mandrel unit 107 of this embodiment is very similar to that of the above-described first embodiment, and differs only in the configuration of the edge and corner sections 127a-d, 129a-d of the mandrel plate 119.

In this embodiment each of the edge sections 127a-d comprises a first, hook surface 163, here of arcuate shape, which extends outwardly and rearwardly from the respective edge of the deposition surface 121 and returns inwardly and rearwardly to a location spaced rearwardly from and laterally inwardly of the respective edge of the deposition surface 121, a second, inclined surface 165 which extends inwardly and rearwardly from the rear, distal end of the hook surface 163, and a third, recessed surface 167 which extends from the inner end of the inclined surface 165 to the other major surface 125 in a direction substantially perpendicular to the deposition surface 121. As will be described in more detail hereinbelow, major regions of the hook surfaces 163 remain exposed to receive metal deposit, resulting in inwardly-directed, hook-shaped attachment elements E of the formed printing screen S.

In this embodiment the first to fourth non-conductive edge elements 143a-d each shield a region of the distal end of the hook surface 163 and the inclined and recessed surfaces 165, 167 of a respective one of the edge sections 127a-d, leaving major regions of the hook surfaces 163 of the edge sections 127a-d exposed to receive metal deposit.

In this embodiment the non-conductive corner elements 145a-d each shield a respective one of the corner sections 129a-d, such that deposit is received only on the substantially straight edge sections 127a-d.

In this embodiment the exposed regions of the hook surfaces 163, and thus the attachment elements E of the printing screen S, have a lateral projection p in a plane parallel to the deposition surface 121 of about 0.5 mm. As a consequence of the relatively small extent of the lateral projection p and the rearward and inward arcuate extension of the hook surface 163, and thus the attachment elements E of the printing screen S, the resilience, albeit limited, of the printing screen S allows the printing screen S to be released from the mandrel 115.

In operation, the power supply unit 111 is actuated to drive an electric current through the electrolyte solution 105 between the mandrel unit 107 and the anode unit 109. This current causes metal ions to migrate from the anode plate 151 to the exposed surfaces of the mandrel plate 119, at which exposed surfaces, that is, the exposed regions of the deposition surface 121 and the exposed regions of the hook surface 163 of the edge sections 127a-d, the metal ions deposit as the metal, building up the printing screen S by continued deposition on the mandrel plate 119.

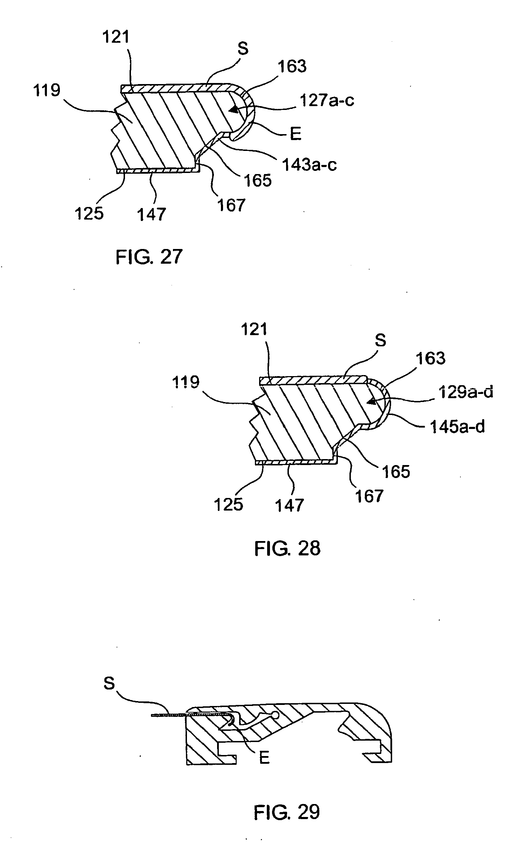

This process is allowed to continue until a deposit of the required thickness, which constitutes the printing screen S, has been built up on the mandrel 115, as illustrated in Figures 27 and 28, at which point the power supply unit 111 is de-actuated and the mandrel unit 107 removed from the bath 103. Figures 27 and 28 illustrate a printing screen S in accordance with a third embodiment of the present invention, which includes attachment elements E at the respective edges thereof.

The non-conductive elements 141, 143a-d, 145a-d, 147 are then removed, in this embodiment by stripping the resist, leaving the printing screen S.

The printing screen S is then separated from the mandrel 115, and, following cleaning, is ready for use.
Figure 29 illustrates the location of the attachment element E formed at one edge of the printing screen S in a representative frame member of a mounting frame.

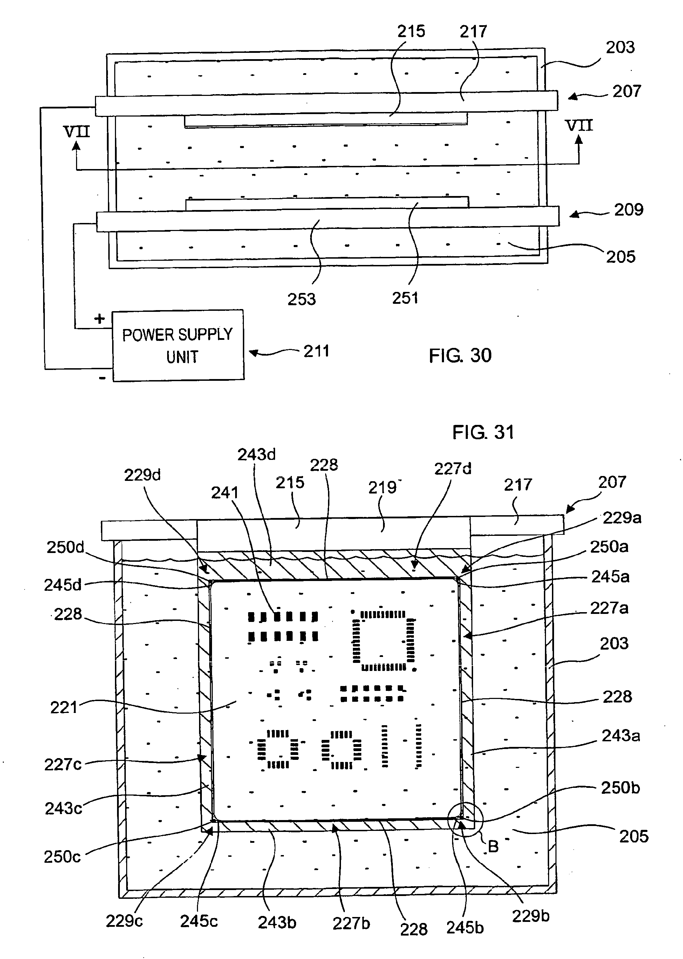

Figures 30 to 36 illustrate an electroforming system in accordance with a second embodiment of the present invention.

The electroforming system comprises a bath 203 which contains an electrolyte solution 205, a mandrel unit 207 which is disposed in the bath 203 and onto which a printing screen S is to be electroformed, an anode unit 209 which is disposed in the bath 203 such as to provide a source of ions of the metal to be deposited, and a power supply unit 211 which is electrically connected to the mandrel unit 207 and the anode unit 209 and operable to drive an electric current through the electrolyte solution 205, with the negative supply of the power supply unit 211 being connected to the mandrel unit 207 and the positive supply of the power supply unit 211 being connected to the anode unit 209.

The electrolyte solution 205 is typically an aqueous solution which contains a dissolved salt of the metal to be deposited, commonly nickel, and levellers which provide for control of the hardness of the deposited metal.

The mandrel unit 207 comprises a mandrel 215 onto which the printing screen S is to be formed, and a supporting member 217, in this embodiment a supporting bar, for supporting the mandrel 215 in the bath 203 and providing an electrical connection therewith.

The mandrel 215 comprises a mandrel plate 219 which includes first and second oppositely-directed flat, major surfaces 221, 225, where one major surface 221 is a deposition surface onto which metal is deposited to form the printing screen S, as will be described in more detail hereinbelow.

In this embodiment the mandrel plate 219 comprises a flat metal plate which includes first to fourth substantially straight edge sections 227a-d, which each include an elongate channel 228 and together define the edges of a rectangle, and, as will become more apparent hereinbelow, the lateral extent of the printing screen S to be electroformed, and first to fourth corner sections 229a-d which connect respective ones of the edge sections 227a-d.

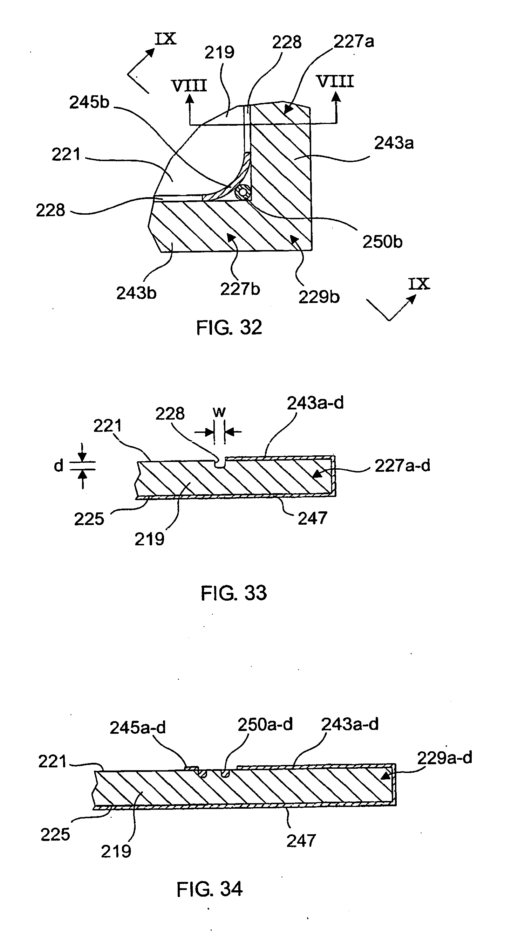

Referring particularly to Figures 32 and 33, in this embodiment each of the channels 228 has a U-shaped section which has a width w of about 0.6 mm and a depth d of about 0.5 mm, such that the channels 228 are sufficiently filled by the deposited metal to form attachment elements E. In another embodiment each of the channels 228 could have a width w of about 0.5 mm. In this embodiment the width w of the channels 228 is such that, when depositing a printing screen which has a thickness of about 0.25 mm, the channels 228 are substantially filled to form attachment elements E in the manner of beads, as will be described in more detail hereinbelow. In other embodiments, where depositing thinner printing screens, particularly at a thickness of about 0.05 mm, the attachment elements E are formed as open sections having a substantially U-shaped section. In this embodiment the channels 228 are cut into the mandrel plate 219, typically by machining or chemical etching.

The mandrel 215 further comprises a plurality of non-conductive aperture-defining elements 241 disposed on the deposition surface 221 which shield regions of the deposition surface 221 onto which metal is not to be deposited, with these elements 241 corresponding to the apertures to be formed in the printing screen S, in this embodiment printing apertures through which a pattern of a printing medium is to be printed.

Referring particularly to Figures 32 and 33, the mandrel 215 further comprises first to fourth non-conductive edge elements 243a-d which each shield a region of the respective edge section 227a-d outside of the rectangle defined by the channels 228 at the edge sections 227a-d, leaving the channels 228 at the edge sections 227a-d exposed to receive metal deposit.

Referring particularly to Figures 32 and 34, the mandrel 215 further comprises first to fourth non-conductive corner elements 245a-d, in this embodiment of arcuate shape, which connect the distal ends of respective ones of the channels 228 at the edge sections 227a-d. In this embodiment the corner elements 245a-d are disposed on the deposition surface 221. As will be described in more detail hereinbelow, the corner elements 245a-d act to prevent the main body of the formed printing screen S extending beyond the distal ends of the channels 228 at the edge sections 227a-d.

The mandrel 215 further comprises a non-conductive surface-covering element 247 which shields the other major surface 225 and the outer edges of the mandrel plate 219, such as to prevent the deposition of metal thereon.

In this embodiment the aperture-defining elements 241 and the corner elements 245a-d are formed of resist, and the edge elements 243a-d and the surface covering element 247 are provided by a permanent coating, here of Teflon (RTM).

The mandrel 215 further comprises first to fourth non-conductive reference elements 250a-d disposed at respective ones of the corner sections 229a-d, which act to provide a means of reference when positioning a photo-mask in patterning the aperture-defining elements 241 relative to the channels 228 at the edge sections 227a-d. In this embodiment the reference elements 250a-d are annular fiducials which are defined by non-conductive annular elements, here formed of an epoxy resin, disposed in an annular channel cut into the mandrel plate 219.

The anode unit 209 comprises an anode plate 251, in this embodiment of the same rectangular shape as the mandrel 215, which is formed of the metal to be deposited as the printing screen S, and a supporting member 253, in this embodiment a supporting bar, for supporting the anode plate 251 in the bath 203 and providing an electrical connection therewith.

In a preferred embodiment the deposition surface 221 of the mandrel plate 219 and the anode plate 251 are disposed in opposed, parallel relation at a predetermined spacing.

In operation, the power supply unit 211 is actuated to drive an electric current through the electrolyte solution 205 between the mandrel unit 207 and the anode unit 209. This current causes metal ions to migrate from the anode plate 251 to the exposed surfaces of the mandrel plate 219, at which exposed surfaces, that is, the exposed regions of the deposition surface 221 and the channels 228 at the edge sections 227a-d, the metal ions deposit as the metal, building up the printing screen S by the continued deposition on the mandrel plate 219.

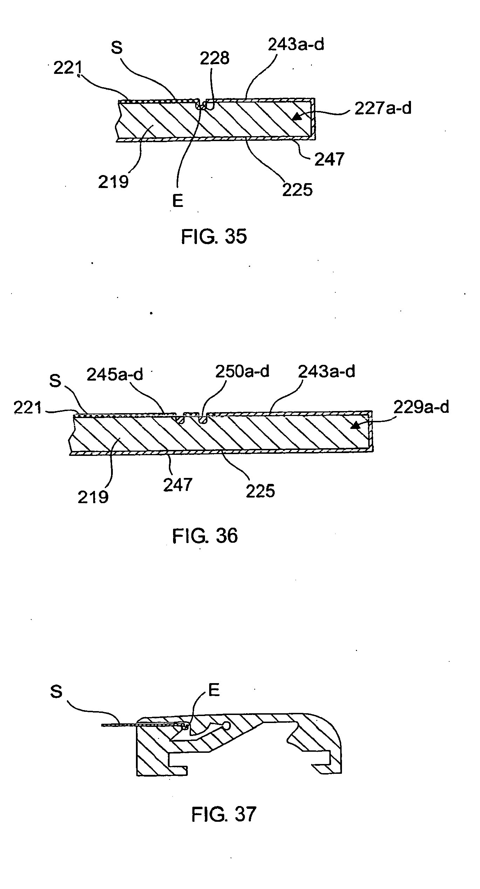

This process is allowed to continue until a deposit of the required thickness, which constitutes the printing screen S, has been built up on the mandrel plate 219, as illustrated in Figures 35 and 36, at which point the power supply unit 211 is de-actuated and the mandrel unit 207 removed from the bath 203. Figures 35 and 36 illustrate a printing screen S in accordance with a fourth embodiment of the present invention, which includes attachment elements E at the respective edges thereof.

The aperture-defining elements 241 and the corner elements 245a-d are then removed, in this embodiment by stripping the resist, leaving the printing screen S.

The printing screen S is then separated from the mandrel plate 219, and, following cleaning, is ready for use.

Figure 37 illustrates the location of the attachment element E formed at one edge of the printing screen S in a representative frame member of a mounting frame.

Finally, it will be understood that the present invention has been described in its preferred embodiments and can be modified in many different ways without departing from the scope of the invention as defined by the appended claims.

## Claims

1. A mandrel for electroforming printing screens (S), the mandrel comprising:
a mandrel plate (119; 219) onto which metal is to be deposited to form a printing screen (S); the mandrel plate (119; 219) including a main deposition surface (121; 221) onto which metal is to be deposited to define a main body of the printing screen (S), at least one pair of edge sections (127a-d; 227a-d) at opposed edges of the main deposition surface (121; 221) which include edge deposition surfaces which extend out of a plane defined by the main deposition surface (121; 221) onto which metal is to be deposited to define attachment elements (E) of the printing screen (S), and corner sections (129a-d; 229a-d) at respective corners of the main deposition surface (121; 221);
non-conductive elements, as edge elements (143a-d; 243a-d), which are disposed at the edge sections (127a-d; 227a-d) such as to define an extent of the edge sections (127a-d; 227a-d); and
non-conductive elements, as corner elements (145a-d; 245a-d), which are disposed at the corner sections (129a-d; 229a-d) such as to shield the same and define an extent of the main deposition surface (121; 221) at the corner sections (129a-d; 229a-d).

2. The mandrel of claim 1, further comprising:
non-conductive elements (141; 241) disposed on the main deposition surface (121; 221) which shield regions of the main deposition surface (121; 221), corresponding to printing apertures, onto which metal is not to be deposited.

3. The mandrel of claim 1 or 2, wherein each edge deposition surface includes a surface section (131; 155; 163) which extends laterally relative to the main deposition surface (121).

4. The mandrel of claim 3, wherein the surface section (131; 163) extends laterally outwardly relative to the respective edge of the main deposition surface (121), which provides for deposition of an outwardly-projecting part.

5. The mandrel of claim 3, wherein the surface section (155; 163) extends laterally inwardly relative to the respective edge of the main deposition surface (121), which provides for deposition of an inwardly-projecting part.

6. The mandrel of claim 5, wherein the surface section (155; 163) returns inwardly a distance of about 0.5 mm.

7. The mandrel of any of claims 3 to 6, wherein the surface section (131; 155) comprises a straight section.

8. The mandrel of any of claims 3 to 6, wherein the surface section (163) comprises an arcuate section.

9. The mandrel of any of claims 3 to 8, wherein the surface section (131; 155; 163) extends rearwardly of the main deposition surface (121).

10. The mandrel of claim 1 or 2, wherein each edge deposition surface includes first and second surface sections (131, 133; 153, 155), wherein the first surface section (133; 153) extends orthogonally relative to the main deposition surface (121) and the second surface section (131; 155) extends laterally relative to the main deposition surface (121).

11. The mandrel of claim 10, wherein the second surface section (131) extends laterally outwardly relative to the respective edge of the main deposition surface (121), which provides for deposition of an outwardly-projecting part.

12. The mandrel of claim 10, wherein the second surface section (155) extends laterally inwardly relative to the respective edge of the main deposition surface (121), which provides for deposition of an inwardly-projecting part.

13. The mandrel of claim 12, wherein the second surface section (155) returns inwardly a distance of about 0.5 mm.

14. The mandrel of any of claims 10 to 13, wherein the second surface section (131; 155) comprises a straight section.

15. The mandrel of any of claims 10 to 13, wherein the second surface section (131; 155) comprises an arcuate section.

16. The mandrel of any of claims 10 to 15, wherein the first surface section (153) extends from the respective edge of the main deposition surface (121) and the second surface section (155) extends from the first surface section (153).

17. The mandrel of any of claims 10 to 15, wherein the second surface section (131) extends from the respective edge of the main deposition surface (121) and the first surface section (133) extends from the second surface section (131).

18. The mandrel of any of claims 10 to 17, wherein the first and second surface sections (131, 133; 153, 155) extend rearwardly of the main deposition surface (121).

19. The mandrel of claim 1 or 2, wherein each edge deposition surface includes first and second surface sections (163), wherein the first surface section (163) extends laterally in one sense relative to the main deposition surface (121) and the second surface section (163) extends laterally in the other sense relative to the main deposition surface (121).

20. The mandrel of claim 19, wherein the first surface section (163) extends laterally outwardly relative to the respective edge of the main deposition surface (121), which provides for deposition of an outwardly-projecting part, and the second surface section (163) extends laterally inwardly relative to the respective edge of the main deposition surface (121), which provides for deposition of an inwardly-projecting part.

21. The mandrel of claim 20, wherein the second surface section (163) returns inwardly a distance of about 0.5 mm.

22. The mandrel of any of claims 19 to 21, wherein one or both of the first and second surface sections (163) comprise a straight section.

23. The mandrel of any of claims 19 to 22, wherein one or both of the first and second surface sections (163) comprise an arcuate section.

24. The mandrel of any of claims 19 to 23, wherein the first and second surface sections (163) extend rearwardly of the main deposition surface (121).

25. The mandrel of claim 1 or 2, wherein the edge sections (227a-d) each comprise a channel (228) at the respective edge of the main deposition surface (221) in which metal is deposited to form an attachment element (E).

26. The mandrel of claim 25, wherein the channel (228) has a width of 0.5 mm to 0.6 mm.

27. The mandrel of claim 25, wherein the channel (228) has a width of about 0.5 mm or about 0.6 mm.

28. The mandrel of any of claims 25 to 27, wherein the channel (228) has a U-shaped section.

29. The mandrel of any of claims 1 to 28, wherein the mandrel plate (119; 219) includes first and second pairs of edge sections (127a-d; 227a-d) at opposed edges of the main deposition surface (121; 221).

30. The mandrel of claim 29, wherein the edge sections (127a-d; 227a-d) and the corner sections (129a-d; 229a-d) define a continuous peripheral section.

31. An electroforming system including the mandrel of any of claims 1 to 30.

32. A method of electroforming printing screens (S), comprising the steps of:
providing the mandrel of any of claims 1 to 30 in an electroforming bath (103; 203); and
electrodepositing metal on the mandrel plate (119; 219) such as to form a printing screen (S).

33. An electroformed printing screen, comprising a main body including a pattern of printing apertures through which a printing medium is in use printed, and at least one pair of attachment elements (E) at opposed edges of the main body, wherein the attachment elements (E) each extend out of a plane defined by the main body and along only part of a length of the respective edge of the main body.

34. The printing screen of claim 33, wherein each corner of the main body is recessed, such that the attachment elements (E) are separate from one another.

35. The printing screen of claim 33 or 34, wherein each attachment element (E) includes a projecting part which extends laterally relative to the respective edge of the main body.

36. The printing screen of claim 35, wherein the projecting part extends laterally outwardly relative to the respective edge of the main body.

37. The printing screen of claim 35, wherein the projecting part extends laterally inwardly relative to the respective edge of the main body.

38. The printing screen of claim 37, wherein the projecting part returns inwardly a distance of about 0.5 mm.

39. The printing screen of any of claims 35 to 38, wherein the projecting part comprises a straight section.

40. The printing screen of any of claims 35 to 38, wherein the projecting part comprises an arcuate section.

41. The printing screen of any of claims 35 to 40, wherein the projecting part extends rearwardly of the main body.

42. The printing screen of claim 33 or 34, wherein each attachment element (E) includes first and second projecting parts, wherein the first projecting part extends orthogonally relative to the main body and the second projecting part extends laterally relative to the main body.

43. The printing screen of claim 42, wherein the second projecting part extends laterally outwardly relative to the respective edge of the main body.

44. The printing screen of claim 42, wherein the second projecting part extends laterally inwardly relative to the respective edge of the main body.

45. The printing screen of claim 44, wherein the second projecting part returns inwardly a distance of about 0.5 mm.

46. The printing screen of any of claims 42 to 45, wherein the second projecting part comprises a straight section.

47. The printing screen of any of claims 42 to 45, wherein the second projecting part comprises an arcuate section.

48. The printing screen of any of claims 42 to 47, wherein the first projecting part extends from the respective edge of the main body and the second projecting part extends from the first projecting part.

49. The printing screen of any of claims 42 to 47, wherein the second projecting part extends from the respective edge of the main body and the first projecting part extends from the second projecting part.

50. The printing screen of any of claims 42 to 49, wherein the first and second projecting parts extend rearwardly of the main body.

51. The printing screen of claim 33 or 34, wherein each attachment element (E) includes first and second projecting parts, wherein the first projecting part extends laterally in one sense relative to the main body and the second projecting part extends laterally in the other sense relative to the main body.

52. The printing screen of claim 51, wherein the first projecting part extends laterally outwardly relative to the respective edge of the main body, and the second projecting part extends laterally inwardly relative to the respective edge of the main body.

53. The printing screen of claim 52, wherein the second projecting part returns inwardly a distance of about 0.5 mm.

54. The printing screen of any of claims 51 to 53, wherein one or both of the first and second projecting parts comprise a straight section.

55. The printing screen of any of claims 51 to 54, wherein one or both of the first and second projecting parts comprise an arcuate section.

56. The printing screen of any of claims 51 to 55, wherein the first and second projecting parts extend rearwardly of the main body.

57. The printing screen of claim 33 or 34, wherein the attachment elements (E) each comprise an open section.

58. The printing screen of claim 57, wherein the open section has a width of 0.5 mm to 0.6 mm.

59. The printing screen of claim 57, wherein the open section has a width of about 0.5 mm or about 0.6 mm.

60. The printing screen of any of claims 57 to 59, wherein the open section comprises a U-shaped section.

61. The printing screen of claim 33 or 34, wherein the attachment elements (E) each comprise a bead.

62. The printing screen of claim 61, wherein the bead has a width of 0.5 mm to 0.6 mm.

63. The printing screen of claim 61, wherein the bead has a width of about 0.5 mm or about 0.6 mm.

64. The printing screen of any of claims 61 to 63, wherein the bead comprises a hollow body.

65. The printing screen of any of claims 33 to 64, comprising first and second pairs of opposed attachment elements (E).

## Patentansprüche

1. Dorn zum Elektroformen von Druckschablonen (S), wobei der Dorn aufweist:
eine Dornenplatte (119, 219) auf die Metall abgeschieden werden soll, um eine Druckschablone (S) zu bilden, wobei die Dornenplatte (119, 219) eine Hauptabscheidungsoberfläche (121, 221), auf die Metall abgeschieden werden soll, um einen Hauptkörper der Druckschablone (S) zu bestimmen, mindestens ein Paar an Kantenabschnitten (127a-d, 227a-d) an gegenüber liegenden Kanten der Hauptabscheidungsoberfläche (121, 221), die Kantenabscheidungsoberflächen umfassen, die sich aus einer Ebene erstrecken, die durch die Hauptabscheidungsoberfläche (121, 221) bestimmt ist und auf die Metall abgeschieden werden soll, um Anbringelemente (E) der Druckschablone (S) zu bestimmen, und Eckenabschnitte (129a-d, 229a-d) an entsprechenden Ecken der Hauptabscheidungsoberfläche (121, 221) aufweist,
nicht leitende Elemente, wie Kantenelemente (143a-d, 243a-d), die an gegenüber liegenden Kantenabschnitten (127a-d, 227a-d) angebracht sind, um eine Ausdehnung der Kantenabschnitten (127a-d, 227a-d) zu bestimmen, und
nicht leitende Elemente, wie Eckenelemente (145a-d, 245a-d), die an den Eckenabschnitten (129a-d, 229a-d) angebracht sind, um diese abzuschirmen und eine Ausdehnung der Hauptabscheidungsoberfläche (121, 221) bei den Eckenabschnitten (129a-d, 229a-d) zu bestimmen.

2. Dorn nach Anspruch 1, der aufweist:
nicht leitende Elemente (141, 241), die an der Hauptabscheidungsoberfläche (121, 221) angebracht sind und die Bereiche der Hauptabscheidungsoberfläche (121, 221) abschirmen, die den Drucköffnungen entsprechen, auf die Metall nicht aufgebracht werden soll.

3. Dorn nach Anspruch 1 oder 2, wobei jede Kantenablagerungsoberfläche einen Oberflächenabschnitt (131, 155, 163) umfasst, der sich lateral in Bezug auf die Hauptabscheidungsoberfläche (121) erstreckt.

4. Dorn nach Anspruch 3, wobei der Oberflächenabschnitt (131, 163) sich lateral nach Außen in Bezug auf die entsprechende Kante der Hauptabscheidungsoberfläche (121) erstreckt, die für eine Abscheidung auf einen nach außen vorstehenden Teil sorgt.

5. Dorn nach Anspruch 3, wobei der Oberflächenabschnitt (155, 163) sich lateral nach Innen in Bezug auf die entsprechende Kante der Hauptabscheidungsoberfläche (121) erstreckt, die für eine Abscheidung auf einen nach Innen vorstehenden Teil sorgt.

6. Dorn nach Anspruch 5, wobei der Oberflächenabschnitt (155, 163) einen Abstand von ungefähr 0,5 mm nach Innen zurückbringt.

7. Dorn nach einem der Ansprüche 3 bis 6, wobei der Oberflächenabschnitt (131, 155) einen geraden Abschnitt aufweist.

8. Dorn nach einem der Ansprüche 3 bis 6, wobei der Oberflächenabschnitt (163) einen bogenförmigen Abschnitt aufweist.

9. Dorn nach einem der Ansprüche 3 bis 8, wobei der Oberflächenabschnitt (131, 155, 163) sich nach hinten zu der Hauptabscheidungsoberfläche (121) erstreckt.

10. Dorn nach Anspruch 1 oder 2, wobei jede Kantenablagerungsoberfläche erste und zweite Oberflächenabschnitte (131, 133, 153, 155) umfasst, wobei der erste Oberflächenabschnitt (133, 153) sich orthogonal in Bezug auf die Hauptabscheidungsoberfläche (121) erstreckt und wobei der zweite Oberflächenabschnitt (131, 155) sich lateral in Bezug auf die Hauptabscheidungsoberfläche (121) erstreckt.

11. Dorn nach Anspruch 10, wobei der zweite Oberflächenabschnitt (131) sich lateral nach Außen in Bezug auf die entsprechende Kante der Hauptabscheidungsoberfläche (121) erstreckt, die für eine Abscheidung auf einen nach außen vorstehenden Teil sorgt.

12. Dorn nach Anspruch 10, wobei der zweite Oberflächenabschnitt (155) sich lateral nach Innen in Bezug auf die entsprechende Kante der Hauptabscheidungsoberfläche (121) erstreckt, die für eine Abscheidung auf einen nach Innen vorstehenden Teil sorgt.

13. Dorn nach Anspruch 12, wobei der zweite Oberflächenabschnitt (155) einen Abstand von ungefähr 0,5 mm nach Innen zurückbringt.

14. Dorn nach einem der Ansprüche 10 bis 13, wobei der zweite Oberflächenabschnitt (131, 155) einen geraden Abschnitt aufweist.

15. Dorn nach einem der Ansprüche 10 bis 13, wobei der zweite Oberflächenabschnitt (131, 155) einen bogenförmigen Abschnitt aufweist.

16. Dorn nach einem der Ansprüche 10 bis 15, wobei der erste Oberflächenabschnitt (153) sich von der entsprechenden Kante der Hauptabscheidungsoberfläche (121) erstreckt und der zweite Oberflächenabschnitt (155) sich von dem ersten Oberflächenabschnitt (153) erstreckt.

17. Dorn nach einem der Ansprüche 10 bis 15, wobei der zweite Oberflächenabschnitt (131) sich von der entsprechenden Kante der Hauptabscheidungsoberfläche (121) erstreckt und der erste Oberflächenabschnitt (133) sich von dem zweiten Oberflächenabschnitt (131) erstreckt.

18. Dorn nach einem der Ansprüche 10 bis 17, wobei der erste und der zweite Oberflächenabschnitt (131, 133; 153, 163) sich von der Hauptabscheidungsoberfläche (121) nach Außen erstrecken.

19. Dorn nach Anspruch 1 oder 2, wobei jede Kantenablagerungsoberfläche einen ersten und einen zweiten Oberflächenabschnitt (163) umfasst, wobei der erste Oberflächenabschnitt (163) sich lateral in eine Richtung in Bezug auf die Hauptabscheidungsoberfläche (121) erstreckt und wobei der zweite Oberflächenabschnitt (163) sich lateral in eine andere Richtung in Bezug auf die Hauptabscheidungsoberfläche (121) erstreckt.

20. Dorn nach Anspruch 19, wobei der erste Oberflächenabschnitt (163) sich lateral nach Außen in Bezug auf die entsprechende Kante der Hauptabscheidungsoberfläche (121) erstreckt, die für die Abscheidung auf einem nach Außen vorstehenden Teil sorgt, und wobei der zweite Oberflächenabschnitt (163) sich lateral nach Innen in Bezug auf die entsprechende Kante der Hauptabscheidungsoberfläche (121) erstreckt, die für die Abscheidung auf einem nach Innen vorstehenden Teil sorgt.

21. Dorn nach Anspruch 20, wobei der zweite Oberflächenabschnitt (163) einen Abstand von ungefähr 0,5 mm nach Innen zurückbringt.

22. Dorn nach einem der Ansprüche 19 bis 21, wobei einer oder beide von dem ersten und dem zweiten Oberflächenabschnitt (163) einen geraden Abschnitt aufweisen.

23. Dorn nach einem der Ansprüche 19 bis 22, wobei einer oder beide von dem ersten und dem zweiten Oberflächenabschnitt (163) einen bogenförmigen Abschnitt aufweisen.

24. Dorn nach einem der Ansprüche 19 bis 23, wobei der erste und der zweite Oberflächenabschnitt (163) sich nach hinten zu der Hauptabscheidungsoberfläche (121) erstrecken.

25. Dorn nach Anspruch 1 oder 2, wobei die Kantenabschnitte (227a-d) jeweils einen Kanal (228) an der entsprechenden Kante der Hauptabscheidungsoberfläche (221) aufweisen, bei der Metall abgeschieden wird, um ein Anbringelement (E) zu bilden.

26. Dorn nach Anspruch 25, wobei der Kanal (228) eine Breite von 0,5 mm bis 0,6 mm aufweist.

27. Dorn nach Anspruch 25, wobei der Kanal (228) eine Breite von ungefähr 0,5 mm oder ungefähr 0,6 mm aufweist.

28. Dorn nach einem der Ansprüche 25 bis 27, wobei der Kanal (228) einen U-förmigen Abschnitt aufweist.

29. Dorn nach einem der Ansprüche 1 bis 28, wobei die Dornenplatte (119, 219) ein erstes und ein zweites Paar an Kantenabschnitten (127a-d, 227a-d) an gegenüber liegenden Kanten der Hauptabscheidungsoberfläche (121, 221) aufweist.

30. Dorn nach Anspruch 29, wobei die Kantenabschnitte (127a-d, 227a-d) und die Eckenabschnitte (129a-d, 229a-d) einen an der Außenseite durchgehenden Abschnitt bestimmen.

31. System zum Elektroformen mit einem Dorn einem der Ansprüche 1 bis 30.

32. Verfahren zum Elektroformen von Druckschablonen (S), wobei das Verfahren aufweist:
ein Bereitstellen eines Dorns nach einem der Ansprüche 1 bis 30 in einem Elektroformbad (103, 203), und
ein Elektroabscheiden von Metall auf die Dornenplatte (119, 219), um eine Druckschablone zu bilden.

33. Elektrogeformte Druckschablone mit einem Hauptkörper, der ein Muster an Drucköffnungen, über die ein Druckmedium während des Gebrauches gedruckt wird, und mindestens ein Paar an Anbringelementen (E) an gegenüber liegenden Kanten des Hauptkörpers aufweist, wobei die Anbringelemente (E) sich jeweils aus einer Ebene erstrecken, die durch den Hauptkörper bestimmt ist, und entlang nur eines Teils der Länge der entsprechende Kante des Hauptkörpers.

34. Druckschablone nach Anspruch 33, wobei jede Ecke des Hauptkörpers eine Aussparung aufweist, so dass die Anbringelemente (E) voneinander getrennt sind.

35. Druckschablone nach Anspruch 33 oder 34, wobei jedes Anbringelement (E) ein vorstehendes Teil aufweist, das sich lateral in Bezug auf die entsprechende Kante des Hauptkörpers erstreckt.

36. Druckschablone nach Anspruch 35, wobei das vorstehende Teil sich lateral nach Außen in Bezug auf die entsprechende Kante des Hauptkörpers erstreckt.

37. Druckschablone nach Anspruch 35, wobei das vorstehende Teil sich lateral nach Innen in Bezug auf die entsprechende Kante des Hauptkörpers erstreckt.

38. Druckschablone nach Anspruch 37, wobei das vorstehende Teil einen Abstand von ungefähr 0,5 mm nach Innen zurückbringt.

39. Druckschablone nach einem der Ansprüche 35 bis 38, wobei das vorstehende Teil einen geraden Abschnitt aufweist.

40. Druckschablone nach einem der Ansprüche 35 bis 38, wobei das vorstehende Teil einen gekrümmten Abschnitt aufweist.

41. Druckschablone nach einem der Ansprüche 35 bis 40, wobei der vorstehende Teil sich nach hinten zu dem Hauptkörper erstreckt.

42. Druckschablone nach Anspruch 33 oder 34, wobei jedes Anbringelement (E) ein erstes und ein zweites vorstehendes Teil aufweist, wobei das erste vorstehende Teil sich orthogonal in Bezug auf den Hauptkörper erstreckt und das zweite vorstehende Teil sich lateral in Bezug auf den Hauptkörper erstreckt.

43. Druckschablone nach Anspruch 42, wobei das zweite vorstehende Teil sich lateral nach Außen in Bezug auf die entsprechende Kante des Hauptkörpers erstreckt.

44. Druckschablone nach Anspruch 42, wobei das zweite vorstehende Teil sich lateral nach Innen in Bezug auf die entsprechende Kante des Hauptkörpers erstreckt.

45. Druckschablone nach Anspruch 44, wobei das zweite vorstehende Teil einen Abstand von ungefähr 0,5 mm nach Innen zurückbringt.

46. Druckschablone nach einem der Ansprüche 42 bis 45, wobei das zweite vorstehende Teil einen geraden Abschnitt aufweist.

47. Druckschablone nach einem der Ansprüche 42 bis 45, wobei das zweite vorstehende Teil einen gekrümmten Abschnitt aufweist.

48. Druckschablone nach einem der Ansprüche 42 bis 47, wobei das erste vorstehende Teil sich von der entsprechenden Kante des Hauptkörpers erstreckt und das zweite vorstehende Teil sich von dem ersten vorstehenden Teil erstreckt.

49. Druckschablone nach einem der Ansprüche 42 bis 47, wobei das zweite vorstehende Teil sich von der entsprechenden Kante des Hauptkörpers erstreckt und das erste vorstehende Teil sich von dem zweiten vorstehenden Teil erstreckt.

50. Druckschablone nach einem der Ansprüche 42 bis 49, wobei das erste und das zweite vorstehende Teil sich nach hinten zu dem Hauptkörpers erstrecken.

51. Druckschablone nach Anspruch 33 oder 34, wobei jedes Anbringelement (E) ein erstes und ein zweites vorstehendes Teil aufweist, wobei das erste vorstehende Teil sich lateral in eine Richtung in Bezug auf den Hauptkörper erstreckt und das zweite vorstehende Teil sich lateral in eine andere Richtung in Bezug auf den Hauptkörper erstreckt.

52. Druckschablone nach Anspruch 51, wobei das erste vorstehende Teil sich lateral nach Außen in Bezug auf die entsprechende Kante des Hauptkörpers erstreckt und das zweite vorstehende Teil sich lateral nach Innen in Bezug auf die entsprechende Kante des Hauptkörpers erstreckt.

53. Druckschablone nach Anspruch 52, wobei das zweite vorstehende Teil einen Abstand von ungefähr 0,5 mm nach Innen zurückbringt.

54. Druckschablone nach einem der Ansprüche 51 bis 53, wobei eins oder beide von dem ersten und dem zweiten vorstehenden Teil einen geraden Abschnitt aufweisen.

55. Druckschablone nach einem der Ansprüche 51 bis 54, wobei eins oder beide von dem ersten und dem zweiten vorstehenden Teil einen gekrümmten Abschnitt aufweisen.

56. Druckschablone nach einem der Ansprüche 51 bis 55, wobei das erste und das zweite vorstehende Teil sich nach hinten zu dem Hauptkörper erstrecken.

57. Druckschablone nach Anspruch 33 oder 34, wobei das Anbringelement (E) jeweils einen offenen Abschnitt aufweist.

58. Druckschablone nach Anspruch 57, wobei der offene Abschnitt eine Breite von 0,5 mm bis 0,6 mm aufweist.

59. Druckschablone nach Anspruch 57, wobei der offene Abschnitt eine Breite von ungefähr 0,5 mm oder ungefähr 0,6 mm aufweist.

60. Druckschablone nach einem der Ansprüche 57 bis 59, wobei der offene Abschnitt einen U-förmigen Abschnitt aufweist.

61. Druckschablone nach Anspruch 33 oder 34, wobei das Anbringelement (E) jeweils eine Sicke aufweist.

62. Druckschablone nach Anspruch 61 wobei die Sicke eine Breite von 0,5 mm bis 0,6 mm aufweist.

63. Druckschablone nach Anspruch 61, wobei die Sicke eine Breite von ungefähr 0,5 mm oder ungefähr 0,6 mm aufweist.

64. Druckschablone nach einem der Ansprüche 61 bis 63, wobei die Sicke einen hohlen Körper aufweist.

65. Druckschablone nach einem der Ansprüche 33 bis 64 mit einem ersten und einem zweiten Paar von gegenüber liegenden Anbringelementen (E).

## Revendications

1. Mandrin pour électroformage d'écrans d'impression (S), le mandrin comprenant :
une plaque de mandrin (119 ; 219) sur laquelle du métal doit être déposé pour former une plaque d'impression (S), la plaque de mandrin (119 ; 219) comprenant une surface de dépôt principale (121 ; 221) sur laquelle du métal doit être déposé pour définir un corps principal de l'écran d'impression (S), au moins une paire de sections de bord (127a-d ; 227a-d) à des bords opposés de la surface de dépôt principale (121 ; 221) qui comprennent des surfaces de dépôt de bord qui s'étendent hors d'un plan défini par la surface de dépôt principale (121 ; 221) sur laquelle du métal doit être déposé pour définir des éléments d'attachement (E) de l'écran d'impression (S), et des sections de coin (129a-d ; 229a-d) à des coins respectifs de la surface de dépôt principale (121 ; 221) ;
des éléments non conducteurs, en tant qu'éléments de bord (143a-d ; 243a-d), qui sont disposés au niveau des sections de bord (127a-d ; 227a-d) de manière à définir une étendue des sections de bord (127a-d ; 227a-d) ; et
des éléments non conducteurs, en tant qu'éléments de coin (145a-d ; 245a-d), qui sont disposés au niveau des sections de coin (129a-d ; 229a-d) de manière à les protéger et à définir une étendue de la surface de dépôt principale (121 ; 221) au niveau des sections de coin (129a-d ; 229a-d).

2. Mandrin selon la revendication 1, comprenant en outre :
des éléments non conducteurs (141 ; 241) disposés sur la surface de dépôt principale (121 ; 221) qui protègent des régions de la surface de dépôt principale (121 ; 221), correspondant à des ouvertures d'impression, sur lesquelles du métal ne doit pas être déposé.

3. Mandrin selon la revendication 1 ou 2, dans lequel chaque surface de dépôt de bord comprend une section de surface (131 ; 155 ; 163) qui s'étend latéralement par rapport à la surface de dépôt principale (121).

4. Mandrin selon la revendication 3, dans lequel la section de surface (131 ; 163) s'étend latéralement vers l'extérieur par rapport au bord respectif de la surface de dépôt principale (121), ce qui permet le dépôt d'une partie se projetant vers l'extérieur.

5. Mandrin selon la revendication 3, dans lequel la section de surface (155 ; 163) s'étend latéralement vers l'intérieur par rapport au bord respectif de la surface de dépôt principale (121), ce qui permet le dépôt d'une partie se projetant vers l'intérieur.

6. Mandrin selon la revendication 5, dans lequel la section de surface (155 ; 163) retourne vers l'intérieur d'une distance d'environ 0,5 mm.

7. Mandrin selon l'une quelconque des revendications 3 à 6, dans lequel la section de surface (131 ; 155) comprend une section droite.

8. Mandrin selon l'une quelconque des revendications 3 à 6, dans lequel la section de surface (163) comprend une section arquée.

9. Mandrin selon l'une quelconque des revendications 3 à 8, dans lequel la section de surface (131 ; 155 ; 163) s'étend vers l'arrière de la surface de dépôt principale (121).

10. Mandrin selon la revendication 1 ou 2, dans lequel chaque surface de dépôt de bord comprend des première et deuxième sections de surface (131, 133 ; 153, 155), dans lequel la première section de surface (133 ; 153) s'étend orthogonalement par rapport à la surface de dépôt principale (121) et la deuxième section de surface (131 ; 155) s'étend latéralement par rapport à la surface de dépôt principale (121).

11. Mandrin selon la revendication 10, dans lequel la deuxième section de surface (131) s'étend latéralement vers l'extérieur par rapport au bord respectif de la surface de dépôt principale (121), ce qui permet le dépôt d'une partie se projetant vers l'extérieur.

12. Mandrin selon la revendication 10, dans lequel la deuxième section de surface (155) s'étend latéralement vers l'intérieur par rapport au bord respectif de la surface de dépôt principale (121), ce qui permet le dépôt d'une partie se projetant vers l'intérieur.

13. Mandrin selon la revendication 12, dans lequel la deuxième section de surface (155) retourne vers l'intérieur d'une distance d'environ 0,5 mm.

14. Mandrin selon l'une quelconque des revendications 10 à 13, dans lequel la deuxième section de surface (131 ; 155) comprend une section droite.

15. Mandrin selon l'une quelconque des revendications 10 à 13, dans lequel la deuxième section de surface (131 ; 155) comprend une section arquée.

16. Mandrin selon l'une quelconque des revendications 10 à 15, dans lequel la première section de surface (153) s'étend du bord respectif de la surface de dépôt principale (121) et la deuxième section de surface (155) s'étend de la première section de surface (153).

17. Mandrin selon l'une quelconque des revendications 10 à 15, dans lequel la deuxième section de surface (131) s'étend du bord respectif de la surface de dépôt principale (121) et la première section de surface (133) s'étend de la deuxième section de surface (131).

18. Mandrin selon l'une quelconque des revendications 10 à 17, dans lequel les première et deuxième sections de surface (131, 133 ; 153, 155) s'étendent vers l'arrière de la surface de dépôt principale (121).

19. Mandrin selon la revendication 1 ou 2, dans lequel chaque surface de dépôt de bord comprend des première et deuxième sections de surface (163), dans lequel la première section de surface (163) s'étend latéralement dans un sens par rapport à la surface de dépôt principale (121) et la deuxième section de surface (163) s'étend latéralement dans l'autre sens par rapport à la surface de dépôt principale (121).

20. Mandrin selon la revendication 19, dans lequel la première section de surface (163) s'étend latéralement vers l'extérieur par rapport au bord respectif de la surface de dépôt principale (121), ce qui permet le dépôt d'une partie de projection vers l'extérieur, et la deuxième section de surface (163) s'étend latéralement vers l'intérieur par rapport au bord respectif de la surface de dépôt principale (121), ce qui permet le dépôt d'une partie de projection vers l'intérieur.

21. Mandrin selon la revendication 20, dans lequel la deuxième section de surface (163) retourne vers l'intérieur d'une distance d'environ 0,5 mm.

22. Mandrin selon l'une quelconque des revendications 19 à 21, dans lequel l'une ou les deux des première et deuxième sections de surface (163) comprend une section droite.

23. Mandrin selon l'une quelconque des revendications 19 à 22, dans lequel l'une ou les deux des première et deuxième sections de surface (163) comprend une section arquée.

24. Mandrin selon l'une quelconque des revendications 19 à 23, dans lequel les première et deuxième sections de surface (163) s'étendent vers l'arrière de la surface de dépôt principale (121).

25. Mandrin selon la revendication 1 ou 2, dans lequel les sections de bord (227a-d) comprennent chacune un canal (228) au niveau du bord respectif de la surface de dépôt principale (221) dans lequel du métal est déposé pour former un élément d'attachement (E).

26. Mandrin selon la revendication 25, dans lequel le canal (228) a une largeur de 0,5 mm à 0,6 mm.

27. Mandrin selon la revendication 25, dans lequel le canal (228) a une largeur d'environ 0,5 mm ou d'environ 0,6 mm.

28. Mandrin selon l'une quelconque des revendications 25 à 27, dans lequel le canal (228) a une section en forme de U.

29. Mandrin selon l'une quelconque des revendications 1 à 28, dans lequel la plaque de mandrin (119 ; 219) comprend des première et deuxième paires de sections de bord (127a-d ; 227a-d) à des bords opposés de la surface de dépôt principale (121 ; 221).

30. Mandrin selon la revendication 29, dans lequel les sections de bord (127a-d ; 227a-d) et les sections de coin (129a-d ; 229a-d) définissent une section périphérique continue.

31. Système d'électroformage comprenant le mandrin selon l'une quelconque des revendications 1 à 30.

32. Procédé d'électroformage d'écrans d'impression (S), comprenant les étapes suivantes :
fournir le mandrin selon l'une quelconque des revendications 1 à 30 dans un bain d'électroformage (103 ; 203) ; et
électro-déposer du métal sur la plaque de mandrin (119 ; 219) de manière à former un écran d'impression (S).

33. Ecran d'impression électroformé, comprenant un corps principal comprenant un motif d'ouvertures d'impression à travers lesquelles un support d'impression est en utilisation imprimé, et au moins une paire d'éléments d'attachement (E) à des bords opposés du corps principal, dans lequel les éléments d'attachement (E) s'étendent chacun hors d'un plan défini par le corps principal et le long uniquement d'une partie d'une longueur du bord respectif du corps principal.

34. Ecran d'impression selon la revendication 33, dans lequel chaque coin du corps principal est renfoncé, de sorte que les éléments d'attachement (E) sont séparés l'un de l'autre.

35. Ecran d'impression selon la revendication 33 ou 34, dans lequel chaque élément d'attachement (E) comprend une partie de projection qui s'étend latéralement par rapport au bord respectif du corps principal.

36. Ecran d'impression selon la revendication 35, dans lequel la partie de projection s'étend latéralement vers l'extérieur par rapport au bord respectif du corps principal.

37. Ecran d'impression selon la revendication 35, dans lequel la partie de projection s'étend latéralement vers l'intérieur par rapport au bord respectif du corps principal.

38. Ecran d'impression selon la revendication 37, dans lequel la partie de projection retourne vers l'intérieur d'une distance d'environ 0,5 mm.

39. Ecran d'impression selon l'une quelconque des revendications 35 à 38, dans lequel la partie de projection comprend une section droite.

40. Ecran d'impression selon l'une quelconque des revendications 35 à 38, dans lequel la partie de projection comprend une section arquée.

41. Ecran d'impression selon l'une quelconque des revendications 35 à 40, dans lequel la partie de projection s'étend vers l'arrière du corps principal.

42. Ecran d'impression selon la revendication 33 ou 34, dans lequel chaque élément d'attachement (E) comprend des première et deuxième parties de projection, dans lequel la première partie de projection s'étend orthogonalement par rapport au corps principal et la deuxième partie de projection s'étend latéralement par rapport au corps principal.

43. Ecran d'impression selon la revendication 42, dans lequel la deuxième partie de projection s'étend latéralement vers l'extérieur par rapport au bord respectif du corps principal.

44. Ecran d'impression selon la revendication 42, dans lequel la deuxième partie de projection s'étend latéralement vers l'intérieur par rapport au bord respectif du corps principal.

45. Ecran d'impression selon la revendication 44, dans lequel la deuxième partie de projection retourne vers l'intérieur d'une distance d'environ 0,5 mm.

46. Ecran d'impression selon l'une quelconque des revendications 42 à 45, dans lequel la deuxième partie de projection comprend une section droite.

47. Ecran d'impression selon l'une quelconque des revendications 42 à 45, dans lequel la deuxième partie de projection comprend une section arquée.

48. Ecran d'impression selon l'une quelconque des revendications 42 à 47, dans lequel la première partie de projection s'étend du bord respectif du corps principal et la deuxième partie de projection s'étend de la première partie de projection.

49. Ecran d'impression selon l'une quelconque des revendications 42 à 47, dans lequel la deuxième partie de projection s'étend du bord respectif du corps principal et la première partie de projection s'étend de la deuxième partie de projection.

50. Ecran d'impression selon l'une quelconque des revendications 42 à 49, dans lequel les première et deuxième parties de projection s'étendent vers l'arrière du corps principal.

51. Ecran d'impression selon la revendication 33 ou 34, dans lequel chaque élément d'attachement (E) comprend des première et deuxième parties de projection, dans lequel la première partie de projection s'étend latéralement dans un sens par rapport au corps principal et la deuxième partie de projection s'étend latéralement dans l'autre sens par rapport au corps principal.

52. Ecran d'impression selon la revendication 51, dans lequel la première partie de projection s'étend latéralement vers l'extérieur par rapport au bord respectif du corps principal, et la deuxième partie de projection s'étend latéralement vers l'intérieur par rapport au bord respectif du corps principal.

53. Ecran d'impression selon la revendication 52, dans lequel la deuxième partie de projection retourne vers l'intérieur d'une distance d'environ 0,5 mm.

54. Ecran d'impression selon l'une quelconque des revendications 51 à 53, dans lequel l'une ou les deux des première et deuxième parties de projection comprennent une section droite.

55. Ecran d'impression selon l'une quelconque des revendications 51 à 54, dans lequel l'une ou les deux des première et deuxième parties de projection comprennent une section arquée.

56. Ecran d'impression selon l'une quelconque des revendications 51 à 55, dans lequel les première et deuxième parties de projection s'étendent vers l'arrière du corps principal.

57. Ecran d'impression selon la revendication 33 ou 34, dans lequel les éléments d'attachement (E) comprennent chacun une section ouverte.

58. Ecran d'impression selon la revendication 57, dans lequel la section ouverte a une largeur de 0,5 mm à 0,6 mm.

59. Ecran d'impression selon la revendication 57, dans lequel la section ouverte a une largeur d'environ 0,5 mm ou d'environ 0,6 mm.

60. Ecran d'impression selon l'une quelconque des revendications 57 à 59, dans lequel la section ouverte comprend une section en forme de U.

61. Ecran d'impression selon la revendication 33 ou 34, dans lequel les éléments d'attachement (E) comprennent chacun un filet.

62. Ecran d'impression selon la revendication 61, dans lequel le filet a une largeur de 0,5 mm à 0,6 mm.

63. Ecran d'impression selon la revendication 61, dans lequel le filet a une largeur d'environ 0,5 mm ou d'environ 0,6 mm.

64. Ecran d'impression selon l'une quelconque des revendications 61 à 63, dans lequel le filet comprend un corps creux.

65. Ecran d'impression selon l'une quelconque des revendications 33 à 64, comprenant des première et deuxième paires d'éléments d'attachement (E) opposés.
